Europäisches Patentamt

European Patent Office

Office européen des brevets

(11) Veröffentlichungsnummer: **0 342 478**
**A2**

(12) **EUROPÄISCHE PATENTANMELDUNG**

(21) Anmeldenummer: 89108302.4

(22) Anmeldetag: 09.05.89

(51) Int. Cl.⁴: **F16B 12/30** , **H05K 7/18**

(30) Priorität: 14.05.88 DE 3816516

(43) Veröffentlichungstag der Anmeldung:
23.11.89 Patentblatt 89/47

(84) Benannte Vertragsstaaten:
**BE DE ES FR LU NL**

(71) Anmelder: **Fritz Schäfer Gesellschaft mit beschränkter Haftung**
**Fritz-Schäfer-Strasse 20**
**D-5908 Neunkirchen(DE)**

(72) Erfinder: **Schäfer, Gerhard**
**Oberes Gerstenfeld 2**
**D-5908 Neunkirchen-Salchendorf(DE)**

(74) Vertreter: **Müller, Gerd et al**
**Patentanwälte**
**HEMMERICH-MÜLLER-GROSSE-POLLMEIER--**
**MEY-VALENTIN Hammerstrasse 2**
**D-5900 Siegen 1(DE)**

(54) **Sockel für einen Schaltschrank oder dergleichen.**

(57) Es wird ein Sockel 3 für einen Schaltschrank vorgeschlagen, der aus vier Eckstücken 4a, 4b, 4c, 4d sowie zwei Querblenden 5a, 5b und zwei Längsblenden 6a und 6b zusammengesetzt werden kann.

Als Kupplungsmittel werden dabei Verbindungsbolzen 29 in Form von Kopfbolzen benutzt, deren an den Kopf 32 anschließender Schaft 33 einen Polygonquerschnitt hat. Er kann in seinem Schaftquerschnitt entsprechend profilierte Durchbrüche 21, 22 von Blenden-Befestigungsflanschen 15, 16 der Eckstücke 4a bis 4d eingesetzt sowie anschließend verdrehungssicher mit randoffenen Ausklinkungen 27, 28 in Querseitenwänden 25, 26 der Querblenden 5a, 5b und Längsblenden 6a, 6b eingerückt werden. Anschließend werden durch Senklöcher 36 in den Stirnwänden 23 der Querblenden 5a, 5b und Längsblenden 6a, 6b Sicherungsschrauben 35 in Eingriffsgewinde der Verbindungsbolzen 29 eingedreht, um die Kupplungslage der Verbindungsbolzen 29 relativ zu den Eckstücken 4a bis 4d sowie den Querblenden 5a, 5b und Längsblenden 6a, 6b zu fixieren.

FIG.2

EP 0 342 478 A2

## Sockel für einen Schaltschrank oder dergleichen

Die Erfindung betrifft einen Sockel für einen Schaltschrank oder dergleichen, welcher aus vier winkelförmigen Eckstücken sowie mindestens zwei Querblenden und mindestens zwei Längsblenden zu einem Rahmen zusammenbaubar ist, bei dem die Eckstücke zwei im rechten Winkel zueinander stehende, vertikale Außenwände und daran wiederum unter einem rechten Winkel anschließende, vertikale Blenden-Befestigungsflansche mit mindestens einer Ausnehmung zur Aufnahme eines Verbindungsbolzens, sowie unten und oben horizontale, mit Schrank-Befestigungs-Durchbrüchen versehene Schrank-Befestigungsflansche aufweisen, und bei dem die boxartig ausgebildeten Quer- und Längsblenden an ihren Stoßstellen zu den Eckstücken so mit den zugehörigen Blenden-Befestigungsflanschen der Eckstücke verbindbar sind, daß sie bündig an die Außenflächen der Eckstücke anschließen, während die Blenden-Befestigungsflansche der Eckstücke mit den einander abgekehrten, vertikalen Kanten der Außenwände der Eckstücke einstückig ausgebildet, rechtwinklig nach innen gebogen und mit den Querblenden und Längsblenden verbindbar sind, die dazu in ihren als Stoßstellen dienenden Quer-Seitenwänden mindestens eine Ausnehmung aufweisen, welche mit der Ausnehmung in den Blenden-Befestigungsflanschen der Eckstücke in Deckungslage bringbar ist.

Ein durch die DE-PS 34 12 291 bekanntgewordener Sockel dieser Gattung zeichnet sich dadurch aus, daß die Eckstücke über ihre Blenden-Befestigungsflansche mit den Querseitenwänden der Querblenden und der Längsblenden verschraubbar sind.

Damit eine minimale Anzahl von Schraubverbindungen ausreicht, um vier Eckstücke, zwei Querblenden und zwei Längsblenden zu einem Rahmen zusammenzubauen, sind bei dem bekannten Sockel die Querseitenwände der Längsblenden an ihren freien Kanten mit nach außen gerichteten Abkantungen versehen, welche die zugekehrten Blenden-Befestigungsflansche der Eckstücke übergreifen und dadurch die Längsblenden gegen Verdrehen sichern. Andererseits werden die Querblenden mit Hilfe von mit Gewindebohrungen versehenen Befestigungsplatten an den zugeordneten Blenden-Befestigungsflanschen der Eckstücke befestigt, wobei die Befestigungsplatten mit einer Abkantung versehen sind, die jeweils den zugekehrten Blenden-Befestigungsflansch und die zugekehrte Querseitenwand der Querblende übergreift und dadurch gegen Verdrehen sichert.

Wesentliche bei dem bekannten Sockel ist dabei, daß die verwendeten Schraubverbindungen jeweils eine Anordnung haben, die ausschließlich von der Innenseite des Sockels her, d.h. nur bei abgenommener Bodenplatte eines auf dem Sockel ruhenden Schaltschrankes, zugänglich ist. Wenn daher bei der Durchführung von Montage- und Wartungsarbeiten an den Schaltschränken die eine oder andere Quer- bzw. Längsblende gelöst werden muß, ist dies nur auf relativ umständliche Art und Weise nämlich erst nach dem Abnehmen der Bodenplatte des Schaltschrankes möglich.

Vielfach ist jedoch erwünscht, zumindest die der öffenbaren Seite des Schaltschrankes zugeordnete Längs- bzw. Querblende des rahmenartigen Sockels so anzuordnen, daß sie im Bedarfsfalle auch ohne Entfernung der Bodenplatte des Schaltschrankes von der Außenseite her gelöst sowie auch anschließend wieder befestigt werden kann, ohne daß die Stabilität bzw. Tragfähigkeit des Sokkels hierdurch beeinträchtigt wird.

Der Erfindung liegt daher die Aufgabe zugrunde, einen Sockel für Schaltschränke der gattungsgemäßen Art so weiterzubilden, daß es mit geringem baulichem Aufwand möglich ist, eine ohne weiteres von außen lösbare Verbindung zwischen den Eckstücken sowie den zugehörigen Quer- und Längsblenden vorzusehen, ohne hierdurch die Tragfähigkeit des Sockels zu beeinträchtigen.

Gelöst wird diese Aufgabe dadurch, daß die Ausnehmung in den Befestigungsflanschen der Endstücke als unrunder, insbesondere polygonförmiger Durchbruch gestaltet ist, während die Ausnehmungen in den Querseitenwänden der Quer- und Längsblenden aus einer randoffenen Ausklinkung bestehen, der in der Stirnwand der Quer- und Längsblende ein Loch, insbesondere Senkloch, zugeordnet ist, daß jeder Verbindungsbolzen aus einem Kopfbolzen mit unrundem, insbesondere polygonförmigem, Schaftquerschnitt besteht, der sowohl mit dem Durchbruch in den Eckstücken als auch mit der randoffenen Ausklinkung in den Quer- und Längsblenden in drehfesten Steckeingriff bringbar ist, und daß der Schaft des Kopfbolzens ein quergerichtetes Eingriffsgewinde enthält, mit dem durch das Loch, insbesondere Senkloch, in der Stirnwand der Quer- und Längsblende eine Sicherungsschraube in Halteeingriff bringbar ist.

Da jeder Verbindungsbolzen über seinen unrunden Schaftquerschnitt mit der dazu passenden Umrißform der Durchbrüche in den Befestigungsflanschen der Eckstücke und den Ausklinkungen in den Querseitenwänden der Quer- und Längsblenden in Wirkverbindung tritt, wird hierdurch auf einfache Art und Weise eine verdrehungssichere Halterung der Quer- und Längsblenden zwischen den Eckstücken erhalten, während die Eingriffslage der Verbindungsbolzen durch die von außen zugänglichen Sicherungsschrauben ordnungsgemäß fixiert ist.

Nach der Erfindung hat es sich besonders bewährt, wenn der Schaft des Verbindungsbolzens bzw. Kopfbolzens einen Vierkantquerschnitt aufweist, dem die Umrißform des Durchbruchs in den Eckstücken und die Begrenzungskanten der Ausklinkung in den Quer- und Längsblenden eng angepaßt ist.

Nach dem Lösen der von außen zugänglichen Sicherungsschrauben kann die jeweilige Quer- bzw. Längsblende leicht und einfach, nämlich quer zu ihrer Längsrichtung von den in den Durchbrüchen der Blenden-Befestigungsflansche der Eckstücke sitzenden Verbindungsbolzen abgezogen werden.

Eine bevorzugte Weiterbildungsmaßnahme der Erfindung besteht auch darin, daß die Blenden-Befestigungsflansche der Eckstücke mit einem Raster von unrunden, insbesondere polygonförmigen Durchbrüchen versehen ist und auch die Querseitenwände der Quer- und Längsblenden zusätzlich zu der Ausklinkung noch entsprechend unrunde, insbesondere polygonförmige Durchbrüche als Aufnahmen für Verbindungsbolzen enthalten.

In diesem Falle ist dann nämlich auch die Möglichkeit gegeben, zwischen den Eckstücken sowie den Quer- und Längsblenden die als Kupplungsmittel dienenden Verbindungsbolzen so einzubauen, daß ein Lösen der Verbindungen nur dann vorgenommen werden kann, wenn zuvor die Bodenplatte des auf dem Sockel ruhenden Schaltschranks entfernt worden ist.

Damit auch bei einer solchen Anordnung der Verbindungsbolzen deren Sicherung in der Eingriffslage bewirkt werden kann, ist erfindungsgemäß weiterhin vorgesehen, daß sich an die Querseitenwände der Quer- und Längsblenden einstückig und parallel zur Stirnwand ausgerichtet ein Endflansch anschließt, in dem sich in Zuordnung zu jedem Durchbruch ein Loch, insbesondere Senkloch, befindet, das eine Aufnahme für eine Sicherungsschraube bildet, die in das Eingriffsgewinde des Verbindungsbolzens eindrehbar ist. Diese Anordnung der Sicherungsschrauben für die Verbindungsbolzen ist bei auf dem Sockel ruhendem bzw. befestigtem Schaltschrank nur nach Abnahme von dessen Bodenplatte zugänglich.

Nach der Erfindung erweist es sich als vorteilhaft, wenn die rasterartig in einer Reihe übereinander vorgesehenen Durchbrüche in den Blenden-Befestigungsflanschen der Eckstücke symmetrisch zu einer horizontalen Mittelebene derselben angeordnet sind und dabei vorzugsweise eine ungerade Anzahl, z.B. fünf oder sieben, Durchbrüche in einer Reihe übereinanderliegen, wobei auch die Querseitenwände der Quer- und Längsblenden zusätzlich zur Ausklinkung Durchbrüche enthalten können, die mit Durchbrüchen in den Blenden-Befestigungsflanschen der Eckstücke in Deckungslage bringbar sind.

Während normalerweise die Bauhöhe der boxartig ausgebildeten Quer- und Längsblenden entsprechend der Bauhöhe der Eckstücke vorgesehen ist, sieht die Erfindung aber auch die Benutzung von Quer- und Längsblenden vor, die nur eine einem Bruchteil der Bauhöhe der Eckstücke entsprechende Bauhöhe haben. Solche Quer- und Längsblenden lassen sich bspw. be nutzen, wenn mehrere Schaltschränke in Reihe nebeneinander und/oder Rücken an Rücken hintereinander aufgestellt werden müssen und dann Kabelverbindungen oder dergleichen zwischen benachbarten Schaltschränken zu verlegen sind, die im Bereich der einander benachbarten Quer- und Längsblenden freie Durchgangs-Höhenbereiche erfordern.

Besonders bewährt hat sich in diesem Falle erfindungsgemäß auch die Benutzung von Quer- und Längsblenden mit einer Bauhöhe, die mindestens etwa um einen halben Rasterabstand der Durchbrüche in den Eckstücken niedriger bemessen ist als die halbe Bauhöhe der Eckstücke. Werden in diesem Falle zwei Quer- bzw. Längsblenden übereinander zwischen den Eckstücken montiert, dann bleibt auf halber Sockelhöhe noch ein Durchgangsspalt frei, welcher in der Regel völlig zum Hindurchführen von Kabelverbindungen oder dergleichen zwischen benachbarten Schaltschränken ausreicht.

In vielen Fällen ist es auch wünschenswert, die Sockel von mehreren in einer Reihe nebeneinander aufgestellten Schaltschränken so miteinander zu kuppeln, daß sie eine vorgegebene Relativstellung zueinander sicher beibehalten.

Um das zu ermöglichen, ist erfindungsgemäß vorgesehen, daß die Eckstücke einander benachbart aufgestellter Sockel miteinander durch eine Querblende kuppelbar sind, die in eine gegenüber ihrer normalen Einbaulage um 90 Grad verdrehten horizontale Lage als Quer-Verbindungsholm zwischen deren Blenden-Befestigungsflansche einsetzbar und mit diesen jeweils über Verbindungsbolzen in Halteeingriff bringbar ist, deren jeder wiederum durch eine in sein Eingriffsgewinde eindrehbare Sicherungsschraube am Endflansch der Querblende fixierbar ist.

Die als Quer-Verbindungsholm benutzte Querblende läßt sich in einem solchen Falle in verschiedenen Höhenlagen zwischen den Eckstücken montieren und damit für unterschiedliche Bedürfnisse unterschiedlich einbauen.

Nach der Erfindung ist auch vorgesehen, daß der Kopf der die Verbindungsbolzen bildenden Kopfbolzen mindestens eine geradlinige Umfangs-Begrenzungskante hat, die sich entweder rechtwinklig oder aber parallel zur Achsebene des Eingriffsgewindes im Bolzenschaft erstreckt. Hierdurch kann nicht nur das Einsetzen der Verbindungsbolzen in Durchbrüche und/oder Ausklinkungen erleichtert, sondern auch die Abstützung der Verbindungsbolzen gegen unerwünschte Verdrehung verbessert werden.

Es ist selbstverständlich, daß die Verbindungsbolzen nur eine solche Gesamtlänge erhalten, daß sie sich bei ihren Ein-und Ausbaumanipulationen innerhalb des in den Eckstücken verfügbaren Hohlraums problemlos handhaben lassen.

In der Zeichnung ist die Erfindung in Ausführungsbeispielen dargestellt. Es zeigen

Figur 1 in schematisch vereinfachter Frontansicht einen auf einem Sockel ruhenden Schaltschrank,

Figur 2 in räumlicher Sprengdarstellung die wesentlichen Teile, aus denen sich rahmenartige Sockel für Schaltschränke zusammenbauen lassen,

Figur 3 einen Schnitt entlang der Linie III-III in Fig. 2 und

Figur 4 wiederum in räumlicher Sprengdarstellung die Verbindungsmöglichkeit zwischen den Sockeln zweier unmittelbar nebeneinander aufzustellender Schaltschränke.

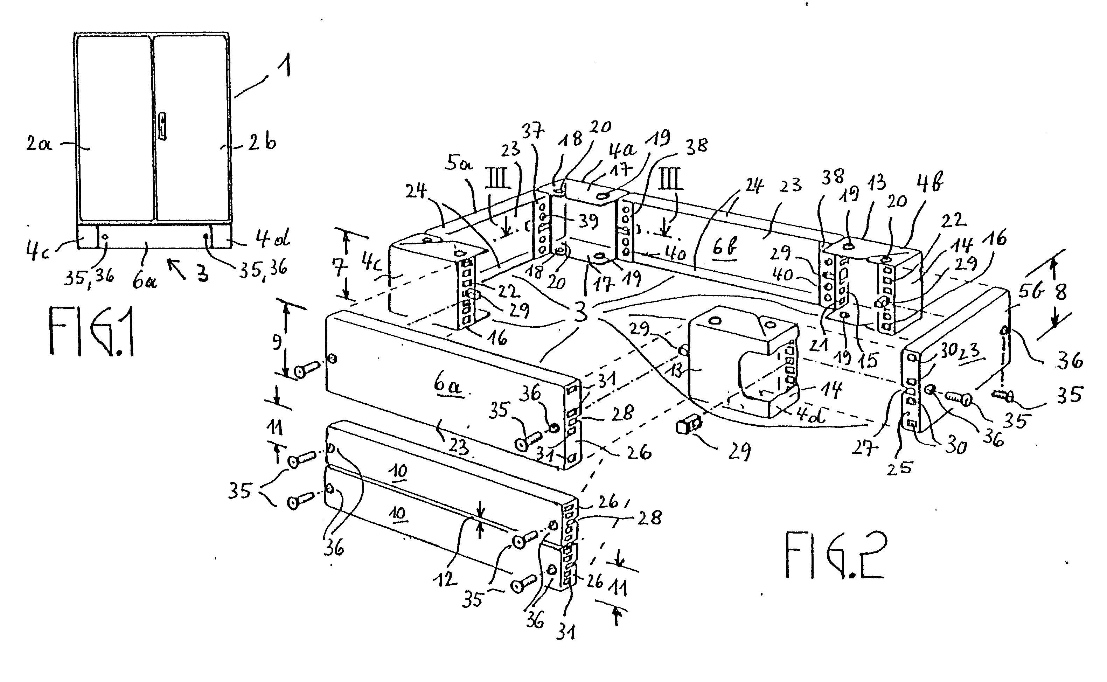

In Fig. 1 der Zeichnung ist ein Schaltschrank 1 zu sehen, der an seiner Frontseite bspw. mit zwei Türen 2a und 2b versehen ist, durch die sein Inneres zugänglich gemacht werden kann.

Der Schaltschrank 1 ruht dabei auf einem Sokkel 3, der in Form eines Rahmens so stabil gestaltet ist, daß er auch Schaltschränke 1 von hohem Gewicht sicher tragen kann.

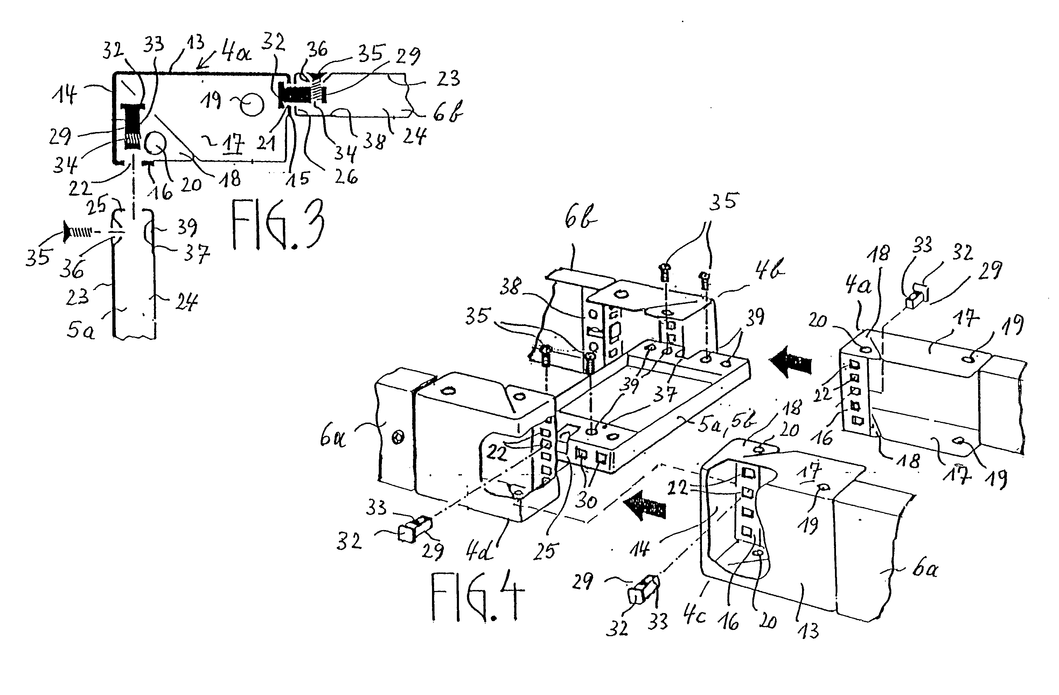

Aufbau und Ausbildung des rahmenartigen Sockels 3 sind aus den Fig. 2 bis 4 der Zeichnung in allen Einzelheiten ersichtlich.

Die Fig. 2 der Zeichnung läßt dabei erkennen, daß der Grundaufbau eines Sockels 3 im wesentlichen acht Schichtkörper-Bauteile umfaßt, die vorzugsweise aus vorgefertigten Blechzuschnitten jeweils durch Abkant-und/oder Biegevorgänge gefertigt sind. Benutzt werden dabei vier Eckstücke 4a, 4b, 4c und 4d, die vorzugsweise völlig baugleich ausgeführt sind. Ferner gehören zu diesem Sockel-Bausatz noch zwei vorzugsweise untereinander baugleiche Querblenden 5a und 5b sowie zwei Längsblenden 6a und 6b, die ebenfalls wiederum untereinander baugleich ausgeführt sein können.

Die Eckstücke 4a, 4b , 4c und 4d haben eine vorgegebene Bauhöhe 7, auf die auch die Bauhöhe 8 der beiden Querblenden 5a und 5b und die Bauhöhe 9 der beiden Längsblenden 6a und 6b abgestimmt ist.

In Fig. 2 ist zusätzlich noch gezeigt, daß in Verbindung mit den Eckstücken 4a, 4b, 4c und 4d gegebenenfalls auch Querblenden und/oder Längsblenden 10 in Benutzung genommen werden können, deren jede nur eine Bauhöhe 11 hat, die einem Bruchteil der Bauhöhe 7 dieser Eckstücke 4a bis 4d entspricht.

Als zweckmäßig hat sich dabei herausgestellt, wenn die Quer-bzw. Längsblenden 10 eine Bauhöhe 11 erhalten, die geringer ist als die Hälfte der Bauhöhe 8 für die Querblenden 5a und 5b bzw. als die Bauhöhe 9 der Längsblenden 6a und 6b. Wird dann der Zwischenraum zwischen zwei Eckstücken 4a, 4c; 4a, 4b; 4b, 4d; 4c, 4d jeweils durch zwei übereinanderliegende Querblenden bzw. Längsblenden 10 überbrückt, dann bleibt zwischen diesen ein gewisser Spaltabstand 12 frei, welcher vorzugsweise als Durchführungsbereich für Kabel oder dergleichen genutzt werden kann.

Aus Fig. 3 der Zeichnung ist anhand des Eckstückes 4a ersichtlich, daß jedes der Eckstücke 4a bis 4d zwei vertikale Außenwände 13 und 14 hat, die relativ zueinander im rechten Winkel verlaufen. Dabei ist erkennbar, daß die Außenwand 13 eine größere Länge hat als die Außenwand 14.

Einstückig und unter einem rechten Winkel abgebogen schließt sich an die Außenwand 13 jedes Eckstücks 4a bis 4d ein Blenden-Befestigungsflansch 15 an, während ein ähnlicher Blenden-Befestigungsflansch 16 einstückig und rechtwinklig auch mit der Außenwand 14 desselben verbunden ist.

Jeweils entlang der horizontalen Ober- und Unterkanten der Außenwand 13 ist rechtwinklig und einstückig ein Schrank-Befestigungsflansch 17 nach einwärts gerichtet abgebogen, während von der Außenwand 14 an deren Oberkante und Unterkante jeweils rechtwinklig und einstückig ein ähnlicher Schrank-Befestigungsflansch 18 nach einwärts abgebogen ist.

Jeder Schrank-Befestigungsflansch 17 ist mit einem Schrank-Befestigungsloch 19 versehen, während jeder Schrank-Befestigungsflansch 18 in entsprechender Weise ein Schrank-Befestigungsloch 20 enthält.

Der Blenden-Befestigungsflansch 15 jedes Eckstücks 4a bis 4d weist eine größere Anzahl von unrunden, zweckmäßigerweise in ihrem Umriß polygonförmigen, insbesondere viereckigen, Durchbrüchen 21 auf und entsprechende Durchbrüche 22 sind auch in dem Blenden-Befestigungsflansch 16 vorgesehen.

Sowohl die Durchbrüche 21 als auch die Durchbrüche 22 sind in einer größeren Anzahl, nach Art eines Rasters, als Reihe übereinander im Blenden-Befestigungsflansch 15 bzw. 16 vorgesehen, und zwar vorzugsweise mit einer ungeraden Anzahl und in der Weise, daß der mittlere Durchbruch der Reihe auf einer mittleren Horizontalebene des jeweiligen Eckstücks 4a bis 4d zu liegen kommt. Es hat sich dabei als vorteilhaft erwiesen, wenn fünf oder sieben Durchbrüche 21 bzw. 22 in einer Reihe übereinander in dem Blenden-Befestigungsflansch 15 bzw. 16 vorgesehen sind.

Sowohl die Querblenden 5a und 5b als auch die Längsblenden 6a und 6b bzw. 10 sind gewissermaßen boxartig ausgestaltet. Sie haben dabei jeweils ein im wesentlichen C-förmiges Querschnittsprofil, bei dem sich an einen eine Stirnwand 23 bildenden Profilsteg einstückig und rechtwinklig zwei Profilflansche 24 anschließen.

An jedem ihrer Enden weisen die Querblenden 5a und 5b jeweils eine rechtwinklig von der Stirnwand 23 abgebogene Querseitenwand 25 auf, die sich auch rechtwinklig zu den Flanschen 24 erstreckt. In entsprechender Weise sind auch die Längsblenden 6a und 6b an beiden Enden mit einer gegenüber ihrer Stirnwand 23 rechtwinklig abgebogenen Querseitenwand 26 ausgestattet, die sich ebenfalls im rechten Winkel zu den Flanschen 24 erstreckt.

Die Querseitenwände 25 der Querblenden 5a und 5b sind jeweils mit einer randoffenen Ausklinkung 27 versehen, deren Begrenzungskanten so verlaufen, daß sie einen polygonförmigen, bspw. rechteckigen Schlitz begrenzen. Dabei ist die Ausklinkung 27 jeweils auf halber Höhe der Bauhöhe 8 der Querblenden 5a und 5b gelegen und somit symmetrisch zu deren horizontaler Mittelebene angeordnet.

In entsprechender Weise ist auch eine Ausklinkung 28 in jeder Querseitenwand 26 der Längsblenden 6a und 6b vorgesehen und ausgebildet.

Haben die Querblenden oder die Längsblenden nur eine Bauhöhe 11, die einem Bruchteil der Bauhöhe 7 der Eckstücke 4a bis 4d entspricht, wie das in Fig. 2 anhand von Längsblenden 10 gezeigt ist, dann befinden sich auch dort die Ausklinkungen 27 bzw. 28 jeweils auf der Hälfte der Bauhöhe 11, so daß sie auch dort mit der horizontalen Längsmittelebene zusammenfallen.

Die Querseitenwände 25 der Querblenden 5a und 5b bzw. die Querseitenwände 26 der Längsblenden 6a und 6b sind aber nicht nur mit den Ausklinkungen 27 bzw. 28 ausgestattet, sondern weisen zusätzlich auch noch Durchbrüche 30 bzw. 31 auf. Diese Durchbrüche 30 und 31 sind dabei in ihrer Ausbil dung auf die Durchbrüche 21 bzw. 22 in den Blenden-Befestigungsflansche 15 bzw. 16 der Eckstücke 4a bis 4d abgestimmt, d.h. sie haben eine Umrißform, die deren polygon-bzw. Viereck-Umrißform entspricht.

Die Abstandslage der Durchbrüche 30 bzw. 31 relativ zueinander und auch relativ zu den Ausklinkungen 27 bzw. 28 ist genau auf das Rastermaß der Durchbrüche 21 und 22 in den Blenden-Befestigungsflanschen 15 und 16 der Eckstücke 4a bis 4d abgestimmt, so daß es keine Schwierigkeiten bereitet, die Ausklinkungen 27 bzw. 28 und die Durchbrüche 30 bzw. 31 an den Querblenden 5a und 5b bzw. an den Längsblenden 6a und 6b auf die Durchbrüche 21 und 22 in den Eckstücken 4a bis 4d auszurichten.

Wichtig ist noch, daß zur Kupplung der Eckstücke 4a bis 4d mit den Querblenden 5a und 5b sowie den Längsblenden 6a und 6b besondere Verbindungsbolzen 29 benutzt werden, die jeweils als Kopfbolzen gestaltet sind. Dabei schließt sich an ihren relativ flachen Kopf 32, der bspw. eine quadratische Umrißform hat, ein Schaft 33 mit geringerer Querschnittsabmessung an, der einen unrunden, vorzugsweise polygonförmigen, Querschnitt hat, bspw. mit einem Vierkantquerschnitt versehen ist. Dieser Vierkantquerschnitt entspricht dabei in seiner Ausgestaltung dem Vierkantquerschnitt der Durchbrüche 21 und 22 in den Blenden-Befestigungsflansche 15 bzw. 16 der Eckstücke 4a bis 4d, aber auch der Umrißform der Durchbrüche 30 bzw. 31 in den Querseitenwänden 25 bzw. 26 der Querblenden 5a, 5b bzw. Längsblenden 6a, 6b. Auch ist der Querschnitt des Schaftes 33 der Verbindungsbolzen 29 von solcher Art, daß sich mit den randoffenen Ausklinkungen 27 bzw. 28 in den Querseitenwänden 25 bzw. 26 der Querblenden 5a, 5b bzw. Längsblenden 6a, 6b ein drehfester Eingriff einstellen kann.

Jeder Verbindungsbolzen 29 weist in seinem Schaft 33 ein quer zu dessen Lägnsachse gerichtetes Eingriffsgewinde 34 für eine Sicherungsschraube 35 auf.

Normalerweise wird zur Kupplung jeder Querblende 5a, 5b bzw. jeder Längsblende 6a, 6b mit den Eckstücken 4a bis 4d jeweils nur ein Verbindungsbolzen 29 benutzt. Dieser wird dabei jeweils durch den mittleren Durchbruch 21 bzw. 22 der Blenden-Befestigungsflansche 15 und 16 des Eckstücks 4a bis 4d von der Rückseite hindurchgesteckt, bis der Kopf 32 zur Stützanlage gelangt. Dabei muß aber dafür Sorge getragen werden, daß das Eingriffsgewinde 34 im Schaft 33 eine solche Lage hat, daß es sich normal bzw. im rechten Winkel zur Hauptebene derjenigen Außenwand 13 bzw. 14 des Eckstücks 4a bis 4d erstreckt, welcher der jeweilige Verbindungsbolzen 29 unmittelbar benachbart liegt. Nunmehr kann eine Querblende 5a bzw. 5b oder eine Längsblende 6a bzw. 6b quer zu ihrer Hauptebene mit den randoffenen Ausklinkungen 27 bzw. 28 ihrer Querseitenwände 25 bzw. 26 auf den Verbindungsbolzen aufgeschoben werden. Sobald dies geschehen ist, braucht dann lediglich noch eine Sicherungsshraube 35 durch ein Senkloch 36 in der Stirnwand 23 der jeweiligen Querblende 5a, 5b bzw. Längsblende 6a, 6b geführt und in das Eingriffsgewinde 34 im Schaft 33 des Verbindungsbolzens 29 eingedreht zu werden, um die Kupplungsverbindung zu vollenden.

Da die Verbindungsbolzen 29 in jeden beliebigen Durchbruch 21 bzw. 22 an den Eckstücken 4a bis 4d eingesetzt werden können, bereitet es keinerlei Schwierigkeiten, wahlweise entweder Querblenden 5a, 5b mit der Bauhöhe 8 und Längsblenden 6a, 6b mit der Bauhöhe 9 oder aber auch Querblenden bzw. Längsblenden 10 mit der Bauhöhe 11 an die Eckstücke 4a bis 4d anzuschließen und dadurch einen stabilen, rahmenartigen Sockel 3 für einen Schaltschrank 1 zu erstellen. Dabei ist es ohne weiteres möglich, im Bedarfsfalle auch irgendeine der Querblenden 5a, 5b oder Längsblenden 6a, 6b von den Eckstücken 4a bis 4d zu lösen, wenn auf dem Sockel 3 ein Schaltschrank ruht. Die Sicherungsschrauben 35 in den Senklöchern 36 liegen außenseitig in den Stirnwänden 23 frei und sind deshalb problemlos zugänglich, ohne daß hierzu die Türen 2a, 2b des Schaltschrankes 1 geöffnet werden müssen.

Unter Benutzung der Verbindungsbolzen 29 und der Sicherungsschrauben 25 können die Eckstücke 4a bis 4d mit den Querblenden 5a, 5b und Längsblenden 6a, 6b nötigenfalls auch so zu einem rahmenartigen Sockel 3 zusammengebaut werden, daß das Lösen irgendeiner Querblende 5a, 5b bzw. Längsblende 6a, 6b nur möglich ist, wenn zuvor die Türen 2a und 2b des auf dem Sockel 3 ruhenden Schaltschrankes 1 geöffnet werden und der Boden des Schaltschrankes 1 entfernt wird.

Zur Erzielung dieses Sicherheitsaufbaues für den Sockel 3 ist es lediglich nötig, einerseits die Querblenden 5a und 5b im Anschluß an ihre Querseitenwände 25 und andererseits auch die Längsblenden 6a und 6b im Anschluß an ihre Querseitenwände 26 mit einem zusätzlichen Endflansch 37 bzw. 38 zu versehen, welcher sich parallel zur Stirnwand 23 erstreckt.

Jeder dieser Endflansche 37 bzw. 38 wird dabei mit einer Reihe von Senklöchern 39 bzw. 40 versehen, wobei die Mittelachse jedes einzelnen Senkloches mit der Mittelachse eines dazu im rechten Winkel liegenden Durchbruchs 30 bzw. 31 der benachbarten Querseitenwand 25 bzw. 26 zusammenfällt.

Werden nunmehr Verbindungsbolzen 29 durch irgendeinen der Durchbrüche 21 und 22 in den Blenden-Befestigungsflansch 15 und 16 der Eckstücke 4a bis 4d in einen zugehörigen Durchbruch 30 bzw. 31 der Querblenden 5a, 5b bzw. Längsblenden 6a, 6b eingeführt, dann ergibt sich hierdurch eine Kupplungsverbindung, die an der Innenseite des rahmenartigen Sockels 3 fixiert werden kann. Hierzu braucht dann lediglich mit dem Eingriffsgewinde 34 des betreffenden Kupplungsbolzens 29 eine Sicherungsschraube 35 in Verbindungseingriff gebracht zu werden, und zwar in der Weise, daß sie durch das betreffende Senkloch 39 bzw. 40 im Endflansch 37 bzw. 38 der Querblende 5a, 5b bzw. Längsblende 6a, 6b eingedreht wird.

In Fig. 4 der Zeichnung ist noch zu sehen, daß gegebenenfalls eine Querblende 5a bzw. 5b auch dazu benutzt werden kann, eine Verbindung zwischen den Eckstücken 4b und 4d eines ersten Sockels sowie den Eckstücken 4a und 4c eines zweiten Sockels herzustellen. Zu diesem Zweck wird dann die Querblende 5a bzw. 5b in einer gegenüber ihrer normalen Einbaulage um 90° verdrehten Einbaulage benutzt. Die Kupplungsverbindung wird auch in diesem Falle durch Benutzung der Verbindungsbolzen 29 und der Sicherungsschrauben 35 hergestellt, wobei die Verbindungsbolzen 29 mit den Durchbrüchen 22 in den Eckstücken und den Durchbrüchen 30 in der Querblende 5a bzw. 5b in Eingriff gelangen.

Die Höhenlage der Querblende 5a, 5b läßt sich bei deren Anordnung gemäß Fig. 4 innerhalb der Bauhöhe 7 der Eckstücke 4a bis 4d den unterschiedlichen Bedürfnissen entsprechend im Rahmen des vorgegebenen Rastermaßes für den Abstand zwischen benachbarten Durchbrüchen 22 frei wählen. Die nicht für den Einbau der Querblende 5a bzw. 5b benötigte Raum ist dann jeweils für Kabeldurchführungen oder dergleichen frei benutzbar.

Abschließend sei nur noch erwähnt, daß die Bauhöhe 11 für die schmalen Quer- bzw. Längsblenden 10, wie sie in Fig. 2 gezeigt sind, vorzugsweise so gewählt ist, daß zwischen zwei übereinanderliegenden Quer- bzw. Längsblenden 10 ein Abstandsspalt 12 gebildet wird, dessen Höhe mindestens gleich dem Mittenabstand zwischen zwei benachbart übereinanderliegenden Durchbrüchen 30 bzw. 31 bemessen ist.

## Ansprüche

1. Sockel für einen Schaltschrank oder dergleichen, welcher aus vier winkelförmigen Eckstücken, mindestens zwei Querblenden und mindestens zwei Längsblenden zu einem Rahmen zusammenbaubar ist, bei dem die Eckstücke zwei im rechten Winkel zueinander stehende, vertikale Außenwände und und daran wiederum unter einem rechten Winkel anschließende vertikale Blenden-Befestigungsflansche mit mindestens einer Ausnehmung zur Aufnahme eines Verbindungsbolzens sowie unten und oben horizontale mit Schrank-Befestigungsdurchbrüchen versehene Schrank-Befestigungsflansche aufweisen, und bei dem die boxartig ausgebildeten Quer- und Längsblenden an ihren Stoßstellen zu den Eckstücken so mit den zugehörigen Blenden-Befestigungsflanschen der Eckstücke verbindbar sind, daß sie bündig an die Außenflächen der Eckstücke anschließen, während die Blenden-Befestigungsflansche der Eckstücke mit den einander abgekehrten, vertikalen Kanten der Außenwände der Eckstücke einstückig ausgebildet, rechtwinklig nach innen gebogen und mit den Querblenden und Längsblenden verbindbar sind, die dazu in ihren als Stoßstellen dienenden Querseitenwänden mindestens eine Ausnehmung aufweisen, welche mit der Ausnehmung in den Blenden-Befestigungsflanschen der Eckstücke in Deckungslage bringbar ist,
**dadurch gekennzeichnet,**
daß die Ausnehmung in den Befestigungsflanschen (15 bzw. 16) der Eckstücke (4a bis 4d) als unrunder, insbesondere polygonförmiger Durchbruch (21 bzw. 22) gestaltet ist, während die Ausnehmung in den Querseitenwänden (25 bzw. 26) der Querblenden (5a, 5b) und Längsblenden (6a, 6b) aus einer randoffenen Ausklinkung (27 bzw. 28) besteht, der in der Stirnwand (23) der Querblende (5a, 5b) und Längsblende (6a, 6b) ein Loch (36), insbesondere Senkloch, zugeordnet ist,
daß der Verbindungsbolzen (29) aus einem Kopfbolzen (32, 33) mit unrundem, insbesondere polygonförmigem Schaftquerschnitt (33) besteht, der sowohl mit dem Durchbruch (21 bzw. 22) in den Eckstücken (4a bis 4d) als auch mit der randoffenen Ausklinkung (27 bzw. 28) in den Querblenden (5a, 5b) und Längsblenden (6a, 6b) in drehfesten Steckeingriff bringbar ist,
und daß der Schaft (33) des Kopfbolzens (32, 33) ein quergerichtetes Eingriffsgewinde (34) enthält, mit dem durch das Loch (36) insbesondere Senkloch, in der Stirnwand (23) der Querblende (5a, 5b) und Längsblende (6a, 6b) eine Sicherungsschraube (35) in Halteeingriff bringbar ist.

2. Sockel nach Anspruch 1,
**dadurch gekennzeichnet,**
daß der Schaft (33) des Verbindungsbolzen (29) einen Vierkantquerschnitt aufweist, dem die Umrißform des Durchbruchs (21 bzw. 22) in den Eckstücken (4a bis 4d) und die Begrenzungskanten der Ausklinkung (27 bzw. 28) in den Querblenden (5a, 5b) und Längsblenden (6a, 6b) eng angepaßt ist.

3. Sockel nach einem der Ansprüche 1 und 2,
**dadurch gekennzeichnet,**
daß die Blenden-Befestigungsflansche (15 und 16) der Eckstücke (4a bis 4d) mit einem Raster von unrunden, insbesondere polygonförmigen Durchbrüchen (21, 22) versehen sind und auch die Querseitenwände (25 bzw. 26) der Querblenden (5a, 5b) und Längsblenden (6a, 6b) zusätzlich zu der Ausklinkung (27 bzw. 28) noch entsprechend unrunde, insbesoandere polygonförmige Durchbrüche (30 bzw. 31) als Aufnahmen für Verbindungsbolzen (29) enthalten.

4. Sockel nach einem der Ansprüche 1 bis 3,
**dadurch gekennzeichnet,**
daß sich an die Querseitenwände (25 bzw. 26) der Querblenden (5a, 5b) und Längsblenden (6a, 6b) einstückig und parallel zur Stirnwand (23) ausgerichtet ein Endflansch (37 bzw. 38) anschließt, in dem sich in Zuordnung zu jedem Durchbruch (30 bzw. 31) ein Loch (39 bzw. 40), insbesondere Senkloch, befindet, das eine Aufnahme für eine Sicherungsschraube (35) bildet, die in das Eingriffsgewinde (34) eines Verbindungsbolzens (29) eindrehbar ist.

5. Sockel nach einem der Ansprüche 1 bis 4,
**dadurch gekennzeichnet,**
daß die Durchbrüche (21 bzw. 22) in den Blenden-Befestigungsflanschen (15 bzw. 16) der Eckstücke (4a bis 4d) symmetrisch zu einer horizontalen Mittelebene derselben angeordnet und dabei vorzugsweise eine ungerade Anzahl, z.B. fünf oder sieben, Durchbrüche (21 bzw. 22) in einer Reihe übereinander vorgesehen sind, und daß auch die Quer-Seitenwände (25 bzw. 26) der Querblenden (5a, 5b) und Längsblenden (6a, 6b) zusätzlich zur Ausklinkung (27 bzw. 28) noch Durchbrüche (30 bzw. 31) enthalten, die mit Durchbrüchen (21 bzw. 22) an den Blenden-Befestigungsflanschen (15 bzw. 16) der Eckstücke (4a bis 4d) in Deckungslage bringbar sind.

6. Sockel nach einem der Ansprüche 1 bis 5,
**gekennzeichnet durch**
Quer- und Längsblenden (10), die eine einem Bruchteil der Bauhöhe (7) der Eckstücke (4a bis 4d) entsprechende Bauhöhe (11) haben.

7. Sockel nach Anspruch 6,
**dadurch gekennzeichnet,**
daß die Quer- und Längsblenden (10) eine Bauhöhe (11) haben, die mindestens etwa um einen halben Rasterabstand der Durchbrüche (21 bzw. 22) in den Eckstücken (4a bis 4d) niedriger bemessen ist als die Hälfte der Bauhöhe (7) der Eckstücke (4a bis 4d).

8. Sockel nach einem der Ansprüche 1 bis 7,
**dadurch gekennzeichnet,**
daß die Eckstücke (4b, 4d und 4a, 4c) einander benachbart aufgestellter Sockel (3) miteinander durch eine Querblende (5a, 5b) kuppelbar sind, die in eine gegenüber ihrer normalen Einbaulage um 90° verdrehten -horizontalen - Lage als Quer-Verbindungsholm zwischen deren Blenden-Befestigungsflansche (16) einsetzbar und mit diesen jeweils über Verbindungsbolzen (29) in Halteeingriff bringbar ist, deren jeder wiederum durch eine in sein Eingriffsgewinde (34) eindrehbare Sicherungsschraube am Endflansch (37) fixierbar ist.

9. Sockel nach einem der Ansprüche 1 bis 8,
**dadurch gekennzeichnet,**
daß der Kopf (32) der die Verbindungsbolzen (29) bildenden Kopfbolzen (32, 33) mindestens eine geradlinige Umfangs-Begrenzungskante hat, die sich entweder rechtwinklig oder aber parallel zur Achsebene des Eingriffsgewindes (34) im Bolzenschaft (33) erstreckt.

FIG.3

FIG.4

EP 0 342 478 A2